# FASCICULE DE BREVET EUROPEEN

(11) **EP 1 708 958 B1**
(45) Date de publication et mention de la délivrance du brevet: **30.01.2008**
(21) Numéro de dépôt: 04805700.4
(22) Date de dépôt: 14.12.2004
(51) Int. Cl.: B81B 7/00

(54) **MICROCOMPOSANT A CAVITE HERMETIQUE COMPORTANT UN BOUCHON ET PROCEDE DE FABRICATION D'UN TEL MICROCOMPOSANT**
MIKROKOMPONENTE MIT ABGEDICHTETEM HOHLRAUM, DER EINEN PFROPFEN UMFASST UND VERFAHREN ZUR HERSTELLUNG SOLCH EINER MIKROKOMPONENTE
MICROCOMPONENT COMPRISING A HERMETICALLY-SEALED CAVITY WITH A PLUG AND METHOD OF PRODUCING ONE SUCH MICROCOMPONENT

(30) Priorité: 19.12.2003 FR 0315031
(43) Date de publication de la demande: 11.10.2006
(73) Titulaire: COMMISSARIAT A L'ENERGIE ATOMIQUE ( CEA), 75015 Paris (FR)
(72) Inventeur: ROBERT, Philippe, F-38100 Grenoble (FR)
(74) Mandataire: Jouvray, Marie-Andrée
(86) Numéro de dépôt international: PCT/FR2004/003217
(87) Numéro de publication internationale: WO 2005/061375

(56) Documents cités:
- EP-A- 1 207 378
- WO-A-01/46066
- WO-A-03/089368
- DE-A- 10 005 555
- US-A- 5 477 008
- GOGOI B P ET AL: "FORCE BALANCED MICROMACHINED PRESSURE SENSORS" IEEE TRANSACTIONS ON ELECTRON DEVICES, IEEE INC. NEW YORK, US, vol. 48, no. 8, août 2001 (2001-08), pages 1575-1584, XP001081085 ISSN: 0018-9383
- KALKMAN A.J. ET AL: 'Transient creep in free-standing thin polycrystalline aluminum films' JOURNAL OF APPLIED PHYSICS vol. 92, no. 9, 01 Novembre 2002, AMERICAN INSTITUTE OF PHYSICS. NEW YORK, US, pages 4968 - 4975, XP012057523
- MODLINSKI ET AL: 'Creep-resistant aluminum alloys for use in MEMS' JOURNAL OF MICROMECHANICS & MICROENGINEERING vol. 15, no. 7, 01 Juillet 2005, INSTITUTE OF PHYSICS PUBLISHING, BRISTOL, GB, pages 165 - 170, XP020091624

## Description

### Domaine technique de l'invention

L'invention concerne un microcomposant comportant une microcavité hermétique, délimitée par un capot dans lequel est formé au moins un orifice, et, sur le capot, une couche de bouchage rendant la microcavité hermétique.

### État de la technique

L'encapsulation hermétique des microsystèmes électromécaniques est nécessaire pour plusieurs raisons. La poussière et l'humidité peuvent, notamment, perturber le fonctionnement des parties mobiles et les contacts électriques peuvent être dégradés par l'oxygène de l'air ambiant.

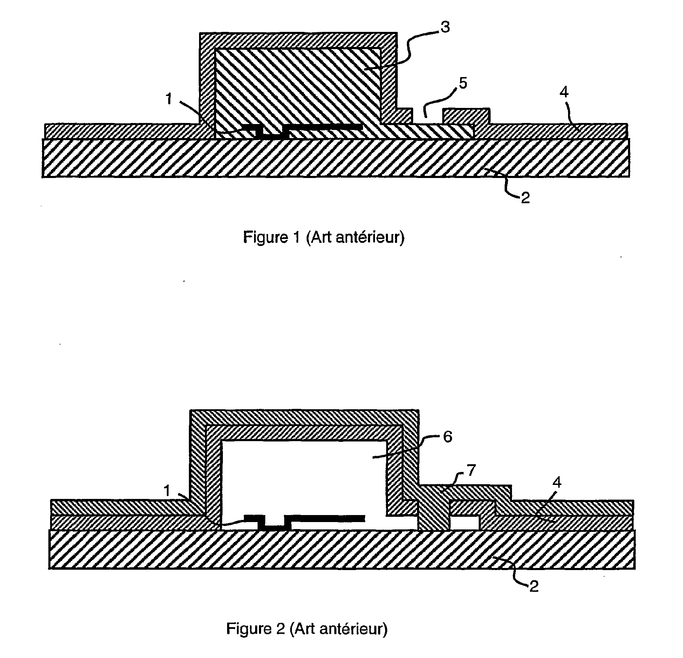

Classiquement, les microsystèmes électromécaniques sont enfermés dans une microcavité hermétique délimitée par un capot. Un procédé de fabrication connu d'un capot hermétique est représenté sur les figures 1 et 2. Les microsystèmes électromécaniques 1 sont généralement disposés sur un substrat 2. Comme représenté à la figure 1, le capot est formé, sur le substrat 2 et sur une couche sacrificielle 3 formée sur le substrat 2 et sur les microsystèmes 1, par une couche solide 4 dans laquelle est formé un orifice 5 ou, éventuellement, plusieurs orifices 5. Puis, la couche sacrificielle 3 est enlevée par l'intermédiaire de l'orifice 5, de manière à obtenir une microcavité 6, comme représenté à la figure 2. Ensuite, une couche de bouchage 7, est déposée sur la couche solide 4 constituant le capot, de manière à rendre la microcavité 6 hermétique.

La fabrication par l'intermédiaire d'une couche sacrificielle 3 présente, entre autres, deux problèmes, à savoir une herméticité insuffisante et une durée importante de l'étape de retrait de la couche sacrificielle 3, en particulier dans le cas de capots 4 de taille importante.

En effet, afin d'assurer un bouchage hermétique du capot 4, les orifices 5 sont typiquement de petite taille et localisés dans des zones de faible épaisseur de la couche sacrificielle 3, et en conséquence de la microcavité 6, comme représenté à la figure 1. Typiquement, l'épaisseur de la couche sacrificielle 3 à l'emplacement de l'orifice 5, dans une zone périphérique de la microcavité 6, est de l'ordre de 0,3 microns, tandis que l'épaisseur de la couche sacrificielle 3 recouvrant les microsystèmes électromécaniques 1 est de l'ordre de 10 microns. L'étape de gravure de la couche sacrificielle 3 est alors longue et difficile. Cet inconvénient est d'autant plus prononcé que, pour assurer au mieux le bouchage, l'épaisseur de la couche sacrificielle 3 à l'emplacement de l'orifice 5 est réduite, parfois en dessous de 0,2 microns.

Le document DE10005555 décrit un microcomposant comportant une cavité hermétique délimitée par un capot. Le capot est constitué par des couches inférieure et supérieure comportant respectivement des orifices décalés les uns par rapport aux autres. Les orifices de la couche supérieure sont fermés par des couches de fermeture, de préférence en aluminium, disposées sur la couche inférieure, sous les orifices. Ainsi, la couche inférieure sert de support solide continu pour les couches de fermeture. Lorsque les couches de fermeture sont en aluminium, une température de 660°C est appliquée pour provoquer la fonte des couches de fermeture. Les couches de fermeture sont disposées entièrement au-dessous de la couche supérieure. Les orifices de la couche supérieure sont ensuite remplis, par une couche de fermeture supplémentaire recouvrant la couche supérieure.

### Objet de l'invention

L'invention a pour but de remédier à ces inconvénients et, en particulier, d'assurer l'herméticité d'une microcavité tout en réduisant la durée du procédé de fabrication de la microcavité.

Selon l'invention, ce but est atteint par les revendications annexées.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
Les figures 1 et 2 représentent deux étapes d'un procédé de fabrication d'un microcomposant selon l'art antérieur.
Les figures 3 à 6 représentent, en coupe, quatre étapes successives d'un mode de réalisation particulier d'un procédé de fabrication d'un microcomposant selon l'invention.
Les figures 7 et 8 représentent, respectivement en vue de dessus et en coupe selon l'axe A-A, l'étape précédant le dépôt de la couche de bouchage d'un autre mode de réalisation particulier d'un procédé de fabrication d'un microcomposant selon l'invention.
La figure 9 représente une étape de pompage d'un mode de réalisation particulier d'un procédé de fabrication d'un microcomposant selon l'invention.

### Description de modes particuliers de réalisation

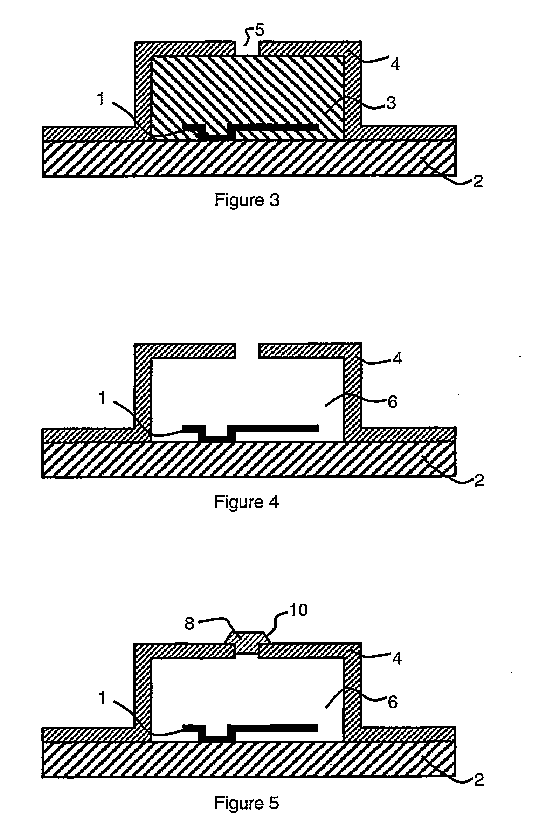

Comme représenté sur les figures 3 et 4, l'orifice 5 gravé dans le capot 4 et débouchant sur la couche sacrificielle 3 est, de préférence, disposé sur une partie sommitale de la microcavité 6, c'est-à-dire à un emplacement ou la couche sacrificielle 3 a une épaisseur maximale, par exemple de l'ordre de 8 à 10 microns. Ainsi, la durée de l'étape ultérieure de création de la microcavité 6 par enlèvement de la couche sacrificielle 3, à travers l'orifice 5, représentée à la figure 4, est diminuée sensiblement par rapport à l'art antérieur.

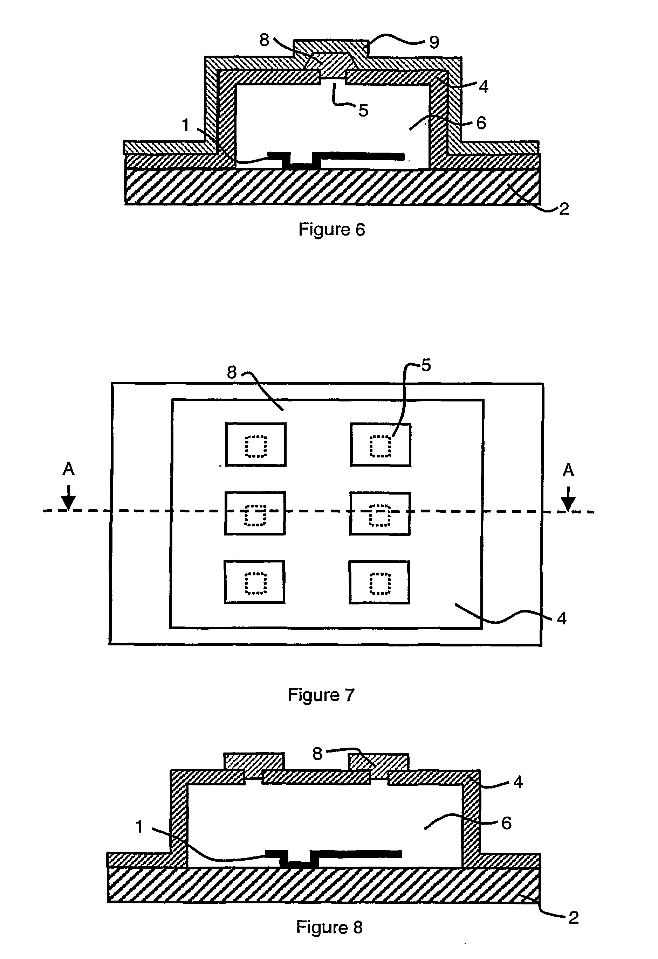

Sur la figure 5, un bouchon 8 est déposé, après enlèvement de la couche sacrificielle 3 et avant dépôt de la couche de bouchage 9, de manière à recouvrir l'orifice 5 et une partie du capot 4 sur la périphérie de l'orifice 5. Le matériau du bouchon 8 est un matériau susceptible de se déformer par fluage. Le matériau susceptible de se déformer par fluage est un matériau polymérisé, notamment choisi parmi les résines photosensibles et le polyimide. Ces matériaux permettent de boucher l'orifice 5 sans pour autant entrer dans la microcavité 6. De plus, ces matériaux supportent les conditions de dépôt de la couche de bouchage 9 destinée à rendre la microcavité 6 hermétique, comme représenté à la figure 6. L'épaisseur du bouchon 8 est, de préférence, comprise entre 2 et 6 micromètres.

Le bouchon peut être réalisé par le dépôt d'une solution de polymère visqueuse recouvrant le capot 4, suivi par la gravure de la couche ainsi obtenue pour délimiter latéralement le bouchon 8.

Il est bien connu que, pour les polymères, les températures appliquées lors du procédé ne doivent pas dépasser les 450°C. L'utilisation de polymères est alors, en particulier, appropriée lorsqu'on veut obtenir des procédés à basse température, c'est-à-dire des procédés dont la température maximale est, par exemple, comprise entre 300°C et 450°C, voire inférieure.

Comme représenté aux figures 5 et 6, le bouchon 8 peut avoir des flancs 10 inclinés, ce qui permet d'améliorer l'adhésion de la couche de bouchage 9 déposée sur le bouchon 8 et, ainsi, d'assurer un bouchage hermétique sans risque de faille.

Afin d'empêcher un dépôt du matériau constituant le bouchon 8 à l'intérieur de la microcavité 6, l'orifice 5 a, de préférence, une dimension inférieure à 5 micromètres. L'orifice 5 peut, par exemple, avoir une section sensiblement rectangulaire de 3µm par 5µm. La gravure de la couche sacrificielle 3 étant ralentie par la réduction de la taille de l'orifice 5, le microcomposant comporte, de préférence, une pluralité d'orifices 5, notamment dans le cas d'un capot 4 de taille importante. Sur les figures 7 et 8, par exemple, six orifices 5 sont agencés sur deux lignes comportant chacune trois orifices 5. Chacun des orifices 5 est bouché par un bouchon 8 associé, recouvrant l'orifice 5 correspondant et une partie du capot 4 sur la périphérie de l'orifice 5, par exemple sur une surface de 20µm par 15µm.

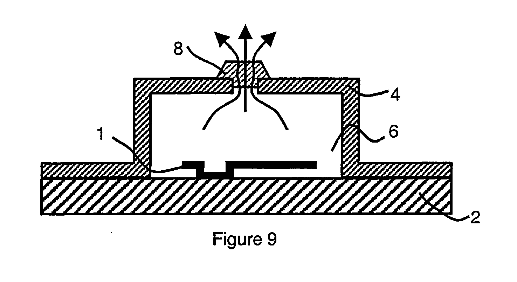

Le bouchon 8 n'est pas nécessairement hermétique. En particulier, le bouchon peut être constitué par un matériau poreux, par exemple par un polymère poreux. Le matériau poreux est, par exemple, une résine photosensible, recuite à une température supérieure à 300°C. Comme illustré à la figure 9, un bouchon 8 poreux permet de pomper du gaz contenu dans la microcavité 6, à travers le matériau poreux, avant le dépôt de la couche de bouchage 9. Ceci permet de contrôler la pression et la nature du gaz à l'intérieur de la microcavité 6 lors de l'étape de bouchage.

Le matériau de la couche sacrificielle 3 peut être un polymère, par exemple du polyimide ou une résine photosensible, permettant une gravure rapide, par exemple une gravure sèche, ou un matériau obtenu par un procédé de type sol gel. Le capot 4 et la couche de bouchage 9 peuvent être en dioxyde de silicium (SiO₂), en nitrure de silicium (Si₃N₄) ou en métal. Le capot 4 peut, par exemple, être réalisé par un dépôt de dioxyde de silicium ayant, par exemple, une épaisseur de 1,5 microns. La couche de bouchage 9 est, de préférence, réalisée par un dépôt de nitrure de silicium d'une épaisseur de 2 microns, par exemple.

L'invention n'est pas limitée aux modes de réalisation particuliers représentés. En particulier, le nombre d'orifices 5 peut être quelconque. Il est éventuellement possible d'associer une même couche, constituant plusieurs bouchons 8, à plusieurs orifices 5.

## Revendications

1. Procédé de fabrication d'une microcavité (6) hermétique d'un microcomposant, comportant successivement :
- le dépôt, sur un substrat (2), d'une couche sacrificielle (3),
- le dépôt, sur le substrat (2) et sur la couche sacrificielle (3), d'une couche constituant un capot (4),
- la gravure, dans le capot (4), d'au moins un orifice (5) débouchant sur la couche sacrificielle (3),
- l'enlèvement de la couche sacrificielle (3), à travers l'orifice (5), de manière à créer la microcavité (6),
- le dépôt d'une couche de bouchage (9), de manière à rendre la microcavité (6) hermétique,
procédé **caractérisé en ce qu'**il comporte, après enlèvement de la couche sacrificielle (3) et avant dépôt de la couche de bouchage (9), le dépôt d'un bouchon (8) en matériau polymère, recouvrant l'orifice (5) et une partie du capot (4) sur la périphérie de l'orifice (5), le bouchage étant réalisé à une température inférieure à 450°C.

2. Procédé selon la revendication 1, **caractérisé en ce que** le bouchon (8) est constitué par un matériau poreux.

3. Procédé selon la revendication 2, **caractérisé en ce que**, le matériau poreux étant une résine photosensible, le procédé comporte une étape de recuit à haute température.

4. Procédé selon l'une des revendications 2 et 3, **caractérisé en ce qu'**il comporte une étape de pompage du gaz contenu dans la microcavité (6), à travers le matériau poreux, avant le dépôt de la couche de bouchage (9).

5. Procédé selon l'une quelconque des revendications 1 à 4, **caractérisé en ce que** le matériau polymérisé est choisi parmi les résines photosensibles et le polyimide.

6. Procédé selon l'une quelconque des revendications 1 à 5, **caractérisé en ce que** l'orifice (5) a une dimension inférieure à 5 micromètres.

7. Procédé selon l'une quelconque des revendications 1 à 6, **caractérisé en ce que** l'orifice (5) est disposé sur une partie sommitale de la microcavité (6).

8. Procédé selon l'une quelconque des revendications 1 à 7, **caractérisé en ce qu'**il comporte la gravure d'une pluralité d'orifices (5).

9. Procédé selon l'une quelconque des revendications 1 à 8, **caractérisé en ce que** l'épaisseur du bouchon (8) est comprise entre 2 et 6 micromètres.

10. Procédé selon l'une quelconque des revendications 1 à 9, **caractérisé en ce que** le bouchon (8) comporte des flancs (10) inclinés.

11. Procédé selon l'une quelconque des revendications 1 à 10, **caractérisé en ce que** le bouchon (8) est non-hermétique.

12. Procédé selon l'une quelconque des revendications 1 à 11, **caractérisé en ce que** le matériau de la couche de bouchage (9) est choisi parmi le dioxyde de silicium, le nitrure de silicium et les métaux.

## Claims

1. Method for production of a hermetically-sealed microcavity (6) of a microcomponent successively comprising
- deposition of a sacrificial layer (3) on a substrate (2),
- deposition of a first layer forming a cover (4), on the substrate (2) and sacrificial layer (3),
- etching, in the cover (4), of at least one hole (5) opening out onto the sacrificial layer (3),
- removal of the sacrificial layer (3), via the hole (5), so as to create the microcavity (6),
- deposition of a sealing layer (9), so as to seal the microcavity (6) hermetically,
method **characterized in that** it comprises deposition of a plug (8) made of a polymeric material, covering the hole (5) and a part of the cover (4) over the periphery of the hole (5), after the sacrificial layer (3) has been removed and before the sealing layer (9) is deposited, sealing being performed at a temperature smaller than 450°C.

2. Method according to claim 1, **characterized in that** the plug (8) is made of a porous material.

3. Method according to claim 2, **characterized in that**, the porous material being a photoresist, the method comprises a high temperature annealing step.

4. Method according to one of the claims 2 and 3, **characterized in that** it comprises a pumping step of the gas contained in the microcavity (6), through the porous material, before the sealing layer (9) is deposited.

5. Method according to any one of the claims 1 to 4, **characterized in that** the polymerized material is selected from photoresists and polyimide.

6. Method according to any one of the claims 1 to 5, **characterized in that** the hole (5) has a dimension smaller than 5 micrometers.

7. Method according to any one of the claims 1 to 6, **characterized in that** the hole (5) is arranged on the highest part of the microcavity (6).

8. Method according to any one of the claims 1 to 7, **characterized in that** it comprises etching of a plurality of holes (5).

9. Method according to any one of the claims 1 to 8, **characterized in that** the thickness of the plug (8) is comprised between 2 and 6 micrometers.

10. Method according to any one of the claims 1 to 9, **characterized in that** the plug (8) comprises sloping sides (10).

11. Method according to any one of the claims 1 to 10, **characterized in that** the plug (8) is non-hermetical.

12. Method according to any one of the claims 1 to 11, **characterized in that** the material of the sealing layer (9) is selected from silicon dioxide, silicon nitride and metals.

## Patentansprüche

1. Verfahren zur Herstellung einer hermetisch verschlossenen Mikrokavität (6) eines Mikrobauteils, das nacheinander umfasst:
- das Aufbringen einer Opferschicht (3) auf ein Substrat (2),
- das Aufbringen einer Schicht, die eine Kappe (4) bildet, auf das Substrat (2) und die Opferschicht (3),
- das Ätzen mindestens einer zur Opferschicht (3) hin mündenden Öffnung (5) in die Kappe (4),
- das Entfernen der Opferschicht (3) durch die Öffnung (5) hindurch, um die Mikrokavität (6) zu schaffen,
- das Aufbringen einer Verschlussschicht (9, 13), um die Mikrokavität (6) hermetisch abzudichten,
Verfahren, das **dadurch gekennzeichnet ist, dass** es nach Entfernen der Opferschicht (3) und vor dem Aufbringen der Verschlussschicht (9) das Aufbringen eines Verschlusses (8) aus polymerem Material umfasst, der die Öffnung (5) und einen Teil der Kappe (4) am Umfang der Öffnung (5) bedeckt, wobei das Verschließen bei einer Temperatur unter 450°C erfolgt.

2. Verfahren nach Anspruch 1, **dadurch gekennzeichnet, dass** der Verschluss (8) aus einem porösen Material besteht.

3. Verfahren nach Anspruch 2, **dadurch gekennzeichnet, dass** das poröse Material ein Fotoresist ist und das Verfahren einen Glühschritt auf hoher Temperatur umfasst.

4. Verfahren nach einem der Ansprüche 2 und 3, **dadurch gekennzeichnet, dass** es einen Schritt des Abpumpens des in der Mikrokavität (6) enthaltenem Gases durch das poröse Material vor dem Aufbringen der Verschlussschicht (9) umfasst.

5. Verfahren nach einem der Ansprüche 1 bis 4, **dadurch gekennzeichnet, dass** das polymerisierte Material aus Fotoresisten und Polyimid ausgewählt ist.

6. Verfahren nach einem der Ansprüche 1 bis 5, **dadurch gekennzeichnet, dass** die Öffnung (5) Abmessungen von unter 5 Mikrometer hat.

7. Verfahren nach einem der Ansprüche 1 bis 6, **dadurch gekennzeichnet, dass** die Öffnung (5) auf einem oberen Bereich der Mikrokavität (6) angeordnet ist.

8. Verfahren nach einem der Ansprüche 1 bis 7, **dadurch gekennzeichnet, dass** es das Ätzen einer Mehrzahl von Öffnungen (5) umfasst.

9. Verfahren nach einem der Ansprüche 1 bis 8, **dadurch gekennzeichnet, dass** die Dicke des Verschlusses (8) 2 bis 6 Mikrometer beträgt.

10. Verfahren nach einem der Ansprüche 1 bis 9, **dadurch gekennzeichnet, dass** der Verschluss (8) geneigte Seitenflächen (10) umfasst.

11. Verfahren nach einem der Ansprüche 1 bis 10, **dadurch gekennzeichnet, dass** der Verschluss (8) nicht hermetisch abdichtet.

12. Verfahren nach einem der Ansprüche 1 bis 11, **dadurch gekennzeichnet, dass** das Material der Verschlussschicht (9) aus Siliziumdioxid, Siliziumnitrid und Metallen ausgewählt ist.
